# EUROPEAN PATENT SPECIFICATION

(11) **EP 4 285 169 B1**
(45) Date of publication and mention of the grant of the patent: **21.01.2026**
(21) Application number: 22702236.5
(22) Date of filing: 26.01.2022
(51) Int. Cl.: G02B 6/42, G02B 6/122, G02B 6/12, H10F 77/40

(54) **PHOTONIC INTEGRATED CIRCUIT**
PHOTONISCHE INTEGRIERTE SCHALTUNG
CIRCUIT INTÉGRÉ PHOTONIQUE

(30) Priority: 26.01.2021 EP 21153528
(43) Date of publication of application: 06.12.2023
(73) Proprietor: AIT Austrian Institute of Technology GmbH, 1210 Wien (AT)
(72) Inventor: HAINBERGER, Rainer, 1210 Wien (AT); MÜLLNER, Paul, 1210 Wien (AT)
(74) Representative: SONN Patentanwälte GmbH & Co KG
(86) International application number: PCT/EP2022/051663
(87) International publication number: WO 2022/161965

(56) References cited:
- EP-A1- 1 115 012
- EP-A1- 3 330 759
- US-A1- 2014 304 971
- US-A1- 2016 087 398
- US-B1- 7 535 944

## Description

The disclosure concerns a photonic integrated circuit, comprising:
- a cladding material;
- a waveguide core in the cladding material, extending in a waveguide core plane and comprising an emitting structure for deflecting and/or scattering and/or emitting the light out of the waveguide core; and
- an optoelectronic component, in particular a photodetector, arranged displaced from the waveguide core plane, wherein the emitting structure of the waveguide core is characterised as the section or a fraction of the section of the waveguide core which is congruent with the optoelectronic component when shifted parallelly perpendicularly to the waveguide core plane.

Furthermore, the disclosure concerns a method for producing a photonic integrated circuit.

Photonic integrated circuits (PICs) are optical waveguide based devices that integrate multiple photonic functions on a single chip. PICs allow the compact and cost-effective realization of a wide range of functional key components for optical data- and telecommunication as well as for sensing applications. In this context, the monolithic integration of optoelectronic components, e.g. photodiodes, is highly demanded, which requires a suitable way of coupling light from the waveguide to the optoelectronic component. PICs fabricated by CMOS-compatible manufacturing processes have attracted strong interest for sensing applications in the sub-1µm wavelength region because silicon based photodiodes and read-out circuitry can be efficiently realized on the same chip.

Traditionally, material systems have been developed, in which the waveguide and the photodiode are located in the same planar layer or vertically stacked in close vicinity and light is coupled directly or by evanescent coupling from the waveguide to the photodiode. However, this approach is not possible for many material systems or is very inefficient, for example for an optoelectronic co-integration in material systems such as a silicon nitride waveguide and a silicon-based optoelectronic chip. Furthermore, there are limitations regarding the designs for the direct or evanescent coupling concepts, eliminating possible applications of the systems.

In particular, if the optoelectronic component cannot be integrated in the same layer as the waveguide or in close vicinity allowing efficient direct or evanescent coupling due to physical or technical limitations, the waveguide and the optoelectronic component have to be placed in separate layers with a large distance, where neither direct nor evanescent coupling can be exploited any more for coupling light from the waveguide to the optoelectronic component. Therefore, the waveguide and the optoelectronic component cannot be in direct contact or evanescently coupled and the waveguide is located e.g. some 1-10 micrometres transversely displaced with respect to the optoelectronic component. The light propagates in the waveguide only in directions parallel to the surface of the optoelectronic component. It is then necessary to efficiently deflect, scatter and/or couple light from the waveguide to the displaced optoelectronic component and at the same time limit crosstalk to other nearby optoelectronic components potentially also included in the PIC in a common plane.

Conventional concepts with redirecting elements lead to emission losses and/or to crosstalk. Furthermore, some concepts, such as a 45° mirror or a 45° end facet of the waveguide, which divert the light by 90°, or a vertically (by 90°) curved waveguide are technologically very difficult to realise and are not practically feasible in large-scale production.

Further waveguide-photodiode couplers are shown in US 2014/304971 A1, EP 1 115 012 A1, US 7,535,944 B1 and EP 3 330 759 A1.

It is an objective of the present disclosure to reduce or alleviate at least one of the problems in the prior art. In particular, it is an objective of the present disclosure to provide a photonic integrated circuit, in which light is efficiently coupled from a waveguide core to an optoelectronic component in a different layer displaced from the waveguide core, where evanescent coupling cannot be exploited anymore. Optionally, such a photonic integrated circuit should be cost-efficiently, reliably and/or large-scale producible.

This is achieved by a photonic integrated circuit as mentioned in the outset, wherein the photonic integrated circuit further comprises a reflection layer for reflecting light emitted from the emitting structure to the optoelectronic component, wherein at least a part of the reflection layer is provided in a reflection plane, which reflection plane intersects with the waveguide core plane, wherein the reflection plane is provided on a side of the emitting structure with respect to a propagation direction of light in the waveguide core in the emitting structure such that light that is emitted by the emitting structure in a sideways direction can be reflected by the reflection layer. Furthermore, this is achieved by a method for producing a photonic integrated circuit, the method comprising the steps of:
- providing for a cladding material with a waveguide core in the cladding material, the waveguide core extending in a waveguide core plane and comprising an emitting structure for deflecting and/or scattering and/or emitting the light out of the waveguide core, and providing for an optoelectronic component arranged displaced from the waveguide core plane, wherein the emitting structure of the waveguide core is characterised as the section or a fraction of the section of the waveguide core which is congruent with the optoelectronic component when shifted parallelly perpendicularly to the waveguide core plane;
- providing for a reflection layer for reflecting light emitted from the emitting structure to the optoelectronic component, wherein at least a part of the reflection layer is provided in a reflection plane, which reflection plane intersects with the waveguide core plane, wherein the reflection plane is provided on a side of the emitting structure with respect to a propagation direction of light in the waveguide core in the emitting structure such that light that is emitted by the emitting structure in a sideways direction can be reflected by the reflection layer.

Thus, at least some of the light, preferably a significant amount of the light, that is emitted by the emitting structure in a direction away from the optoelectronic component is directed to the optoelectronic component by the reflection layer. Thereby, emission losses are reduced and the coupling efficiency of light from the emitting structure to the optoelectronic component is improved. This improved coupling is achieved without the need of having a direct physical contact between the waveguide core and the optoelectronic component or the need for providing the optoelectronic component in close vicinity of the waveguide core for evanescent coupling to the waveguide core.

The PIC is optionally produced by a CMOS (complementary metal-oxide-semiconductor) compatible manufacturing technique. The PIC can comprise a lower layer stack comprising the optoelectronic component and an upper layer stack integrated on top of the lower layer stack, wherein the upper layer stack comprises the cladding material and the waveguide core. The cladding material preferably comprises one or more spacer layers (that is one or more layers having a refractive index which is lower than the refractive index of the waveguide core) separating the waveguide core from the optoelectronic component, in particular comprising a transparent spacer material. The spacer layer, preferably all of the spacer layers together which separate the waveguide core from the optoelectronic component, optionally has (have) a thickness (perpendicular to the waveguide core plane) of several wavelengths, in particular optionally of between 375 nm and 20 µm, further optionally of between 500 nm and 10 µm.

The cladding material is optionally silicon based, in particular comprises SiO₂. The cladding material may comprise at least two different materials. Optionally, the waveguide core and the cladding material comprise different materials. The waveguide core optionally comprises SiN. The waveguide core optionally comprises a waveguide core material with a refractive index that is higher than (optionally at least 1.005-times, further optionally at least 1.025-times) the refractive index of the cladding material, in particular of the material of the cladding material contiguous with the waveguide core. The optoelectronic component is optionally a photodiode, in particular a Si-based photodiode. Optionally, the optoelectronic component is supported by a substrate material, which optionally comprises silicon, in particular a CMOS material and/or a silicon wafer. The waveguide core may be a doped glass waveguide or a polymer waveguide. If the waveguide core is a polymer waveguide, the cladding material preferably comprises polymer.

Optionally, the cladding material is arranged contiguous with the substrate material. Optionally, the reflection layer is arranged (at least partially) contiguous with the cladding material. Optionally, the reflection layer is arranged at least partially contiguous with the waveguide core. Optionally, the waveguide core is embedded in the cladding material. Optionally, the optoelectronic component is arranged opposite the emitting structure, in particular displaced from the emitting structure in a direction perpendicular to the waveguide core plane. The emitting structure of the waveguide core is characterised as the section or a fraction of the section of the waveguide core which is congruent with the optoelectronic component when shifted parallelly perpendicularly to the waveguide core plane. I.e., the emitting structure of the waveguide core may in particular be considered as the section or a fraction of the section of the waveguide core which is above the optoelectronic component.

Optionally, the cladding material and/or the waveguide core are monolithically applied on the optoelectronic component and/or the substrate material supporting the optoelectronic component. Optionally, the waveguide core is displaced from the optoelectronic component (orthogonally to the waveguide core plane) by more than 0.1 µm, further optionally by more than 0.5 µm, further optionally by more than 2 µm, and/or by less than 200 µm, further optionally by less than 50 µm, further optionally by less than 25 µm. The direction of propagation of light in the waveguide core optionally lies in the waveguide core plane. The waveguide core plane is optionally parallel to a surface of the optoelectronic component. Optionally, a boundary of the reflection layer and the cladding material form a reflection interface. The reflection layer can act as a mirror to ensure that some of the light (in particular a significant amount of the light) emitted from the emitting structure is not lost outside (or coupled to potential surrounding cladding layers and cause cross talk).

The waveguide core is in particular suitable for guiding light (which may be introduced into the waveguide core), i.e. optionally the losses of light guided in the waveguide core are less than 1.5 dB/cm outside of the emitting structure, and the emitting structure is suitable (in particular configured) for deflecting and/or scattering and/or emitting light guided in the waveguide core out of the waveguide core. The emitting structure being for emitting light means that at least a fraction of light that may be guided by the waveguide core is emitted at the emitting structure, i.e. emanates from/leaves the waveguide core at the emitting structure. In particular, when light is guided in the waveguide core, the relative optical power emitted at the emitting structure per length unit is at least 10 times higher than the relative optical power lost/emitted in the other part of the waveguide core per length unit (excluding the emitting structure and optionally further emitting structures) for at least one defined wavelength (averaged over the extension of the emitting structure and of the other part of the waveguide core, respectively). The relative optical power emitted/lost per length unit is defined as the optical power per length unit emitted/lost over a certain section divided by the optical power reaching the respective section. The relative optical power emitted/lost per length/unit may be measured in dB/cm. If the emitting structure comprises an end face of the waveguide core, this definition means that the emitting structure comprises an end section of the waveguide core with a non-zero extension, wherein the extension of the end section comprised by the emitting structure is such that including the optical power emitted at the end face, the relative optical power emitted at the emitting structure per length unit is at least 10 times higher than the relative optical power lost/emitted in the other part of the waveguide core per unit length. In particular, the emitting structure being for deflecting and/or scattering and/or emitting light out of the waveguide core means that light that may be guided in the waveguide core leaves the waveguide core in the emitting structure by a deflecting and/or scattering and/or emitting process. The emitting structure being for deflecting and/or scattering and/or emitting the light out of the waveguide core refers in particular to the emitting structure being configured for deflecting and/or scattering and/or emitting light travelling in the waveguide core in the area of the emitting structure out of the waveguide core. The emitting structure being for deflecting and/or scattering and/or emitting the light out of the waveguide core means in particular that the waveguide core comprises in the emitting structure at least one deflecting and/or scattering and/or emitting element. In particular, the waveguide core differs in the emitting structure in at least one feature from the waveguide core in those sections, where the waveguide core is intended to merely guide the light (in particular with minimal losses), and/or the emitting structure comprises an end of the waveguide core.

Optionally, the waveguide core comprises at least two different materials.

Optionally, the waveguide core is a rib-waveguide. I.e., optionally, the waveguide core is not delimited by a particular material, but by a particular structure of the material. In other words, the material forming the waveguide core may also extend beyond the waveguide core in the waveguide core plane. For example, the waveguide core may be delimited by steps (i.e. changes of thickness) in the material forming the waveguide code, i.e. said material may have a larger extension perpendicular to the waveguide core plane in the area where it forms the waveguide core than outside the waveguide core. Generally, the "waveguide core" does not refer to a structure defined by a particular material, but to a structure defined by an optical property to constrain light of a particular wavelength (or, typically, range of wavelengths) to stay within the waveguide core (i.e., it achieves a physical constraint on the transmission of energy out of the waveguide core). Taking into the account the non-zero extension of the waveguide core perpendicular to the waveguide core plane, the waveguide core plane is considered to lie in the centre of the extension of the waveguide core in perpendicular direction to the waveguide core plane. In case the waveguide core is bent toward the optoelectronic component, the waveguide core plane is considered the plane wherein the majority of the waveguide core lies (in the vicinity of the emitting structure). Optionally, the cladding material is a cladding area. The cladding material can be connected or disconnected, i.e. multi-part (in particular in the case of a rib-waveguide).

The reflection layer being for (in particular being configured for) reflecting light emitted from the emitting structure to the optoelectronic component refers to at least a fraction of the light emitted from the emitting structure being reflected to the optoelectronic component. This reflection to the optoelectronic may be a direct single reflection from the reflection layer towards the optoelectronic component or may comprise more than one reflection at the reflection layer, in the end directing the light to the optoelectronic component. Optionally, the reflection layer is arranged such that light emitted from the emitting structure into the half-space with the optoelectronic component is reflected in the direction of the optoelectronic component. The half-space is in particular delimited by the waveguide core plane.

In this disclosure, the term "plane" refers to the geometrical object, i.e. a flat, two-dimensional surface that extends infinitely far. A plane can be characterised by the two arrows (vectors) spanning the plane. The term "layer" refers to a physical object, in particular to a sheet (of a substance or a compound), which may or may not be planar and which has a non-zero thickness (wherein the thickness is defined as the shortest extension).

The step of providing for a cladding material with a waveguide core in the cladding material, the waveguide core extending in a waveguide core plane and comprising an emitting structure for deflecting and/or scattering and/or emitting the light out of the waveguide core, and providing for an optoelectronic component arranged displaced from the waveguide core plane optionally comprises one or more of the steps mentioned in the following steps:
- Providing for a substrate being mechanically sufficiently robust to act as a carrier for all layers, components and structures that are incorporated in this substrate. Typically, these carriers have a disk or sheet shape, where two interfaces are parallel and have a more than 100 times higher surface area than the other remaining surface(s) (e.g. a silicon wafer).
- At least on one of the large interfaces, one or more additional layers are adherently applied to the substrate forming a permanent connection. The process of applying layers to the substrate can be repeated, where the already applied layer acts as carrier for the next. This sequential process is a typical characteristic of such a fabrication process. The additional layers can be directly deposited on the substrate with various kinds of additive methods including epitaxial crystalline layer growth, vacuum technology based processes (e.g. evaporation, chemical vapour deposition, sputtering), polymerisation, precipitation from the liquid phase. The layers can comprise or consist of inorganic materials including semiconducting materials (e.g. Si, Ge), oxides (e.g. glass), insulators (e.g. silicon nitride), metals (e.g. gold, aluminium, platinum) and/or organic materials (e.g. polymers). The substrate and the layers can be modified by doping, oxidization processes and thermal processes.
- Moreover, layers, layer stacks and substrates can be connected to the substrate e.g. via gluing or bonding.
- For the realization of functional components, the substrate and one or more layers are patterned or locally modified using techniques for defining a mask pattern such as photolithography, deep-UV lithography, electron beam writing, laser scanning, and nanoimprinting for masking combined with subtractive methods (e.g. etching or ion milling), additive deposition methods (as described above) using lift-off processes, doping and/or oxidization processes. After the subtractive, additive, and/or modifying process the masking material is removed chemically or physically. Alternatively, maskless processes for etching can be employed.
- If a layer is patterned, all the aforementioned steps can be repeated for the next layer to realise elements with basic electronic or optoelectronic functionality (signal guide, switch, buffer, amplifier, detector) which then can be combined to form a device with complex functionality (integrated circuit). For the fabrication of integrated circuits with certain properties, well-defined processes and process flows are necessary. A very common and highly cost-effective type of fabrication process for integrated circuits is called complementary metal-oxide-semiconductor (CMOS) fabrication process. All devices that can be fabricated with the according process flow are therefore denoted as "CMOS compatible".

The step of providing for a reflection layer for reflecting light emitted from the emitting structure to the optoelectronic component optionally comprises depositing a reflection layer on at least sections of the cladding material. The aforementioned layer deposition process(es) cannot only be used on flat surfaces but also on already patterned structures with a three-dimensional topography. This enables the fabrication of the reflection layer. The fabrication of the reflection layer can additionally include additive, subtractive and/or mixed patterning steps.

Optionally, the reflection layer comprises a different material than the cladding material. Optionally, the reflection layer comprises a material, where
- the absolute value of the refractive index, |n| (wherein |n|=(Sqrt(n_real^2+n_imag^2) with n=n_real + i*n_imag), is higher than (optionally at least 1.5-times, further optionally at least 2-times) the absolute refractive index of the cladding material; and/or
- the real part of the refractive index, n_real, is higher than (optionally at least 1.5-times, further optionally at least 2-times) the real part of the refractive index of the cladding material; and/or
- the imaginary part of the refractive index, n_imag, is higher than (optionally at least 1.5-times, further optionally at least 2-times) the imaginary part of the refractive index of the cladding material.

Thus, a higher fraction of light emitted from the emitting structure towards the reflection layer can be reflected.

Optionally, the reflection layer comprises a metal, in particular aluminium, and/or a dielectric material, which dielectric material preferably has a refractive index at least 2-times the refractive index of the cladding material. The dielectric material is in particular amorphous silicon. Metal, in particular aluminium, provide a high reflection and are easy to deposit on the cladding material.

At least a part of the reflection layer is provided (in particular, extends) in a reflection plane, which reflection plane intersects with the waveguide core plane. I.e., optionally, at least a section of the reflection layer is provided transverse to the waveguide core plane. Optionally, the reflection plane has an angle of between 70° and 145°, in particular of substantially 90°, with respect to the waveguide core plane (for example, the angle is measured between the reflection plane's side facing away from the waveguide core and the waveguide core plane's side facing away from the optoelectronic component). Thus, light emitted from the emitting structure in further directions can be directed to the optoelectronic component. Further, also light that was reflected by the reflection layer once may be reflected by the reflection layer one or more further times and thus be directed to the optoelectronic component. Optionally, at least a part of the reflection layer is (also) provided in a parallel reflection plane, which is substantially parallel to the waveguide core plane. If the reflection layer is provided both in at least one reflection plane intersecting with the waveguide core plane and a parallel reflection plane, a particularly efficient coupling is achieved. Optionally, at least parts of the reflection layer are provided in at least two different reflection planes each intersecting with the waveguide core plane and with each other. Optionally, at least a part of the reflection layer covers at least an area corresponding to the emitting structure parallelly shifted in a direction orthogonal to the waveguide core plane and away from the optoelectronic component.

The reflection plane is provided on a side of the emitting structure with respect to a propagation direction of light in the waveguide core in the emitting structure. In particular, the reflection plane is provided on a side of the emitting structure with respect to the propagation direction of light in the waveguide core in the emitting structure in at least one point of the waveguide core in the emitting structure, optionally in all points of the waveguide core in the emitting structure. Thus, also light that is emitted by the emitting structure in a sideways direction can be reflected by the reflection layer. In case the PIC comprises more than one waveguide-to-optoelectronic component coupling structure (i.e. each including an emitting structure, the light of which should be directed to the respective optoelectronic component), crosstalk between different waveguide-to-optoelectronic component coupling structures can also be reduced.

Optionally, the reflection plane has a distance from the emitting structure of the waveguide core, which distance is measured in a measurement direction in the waveguide core plane and orthogonally to the propagation direction of light in the waveguide core in the emitting structure, wherein the distance is less than the extension of the optoelectronic component on an axis parallel to the measurement direction (and optionally only shifted orthogonally to the waveguide core plane). This means that the reflection plane comprises a point that has a distance from a point of the waveguide core in the emitting structure, which distance is measured in a measurement direction in the waveguide core plane and orthogonally to the propagation direction of light in the point of the waveguide core in the emitting structure, wherein the distance is less than the extension of the optoelectronic component in the measurement direction.

Thus, light that is emitted from the emitting structure in a direction orthogonal to the direction of propagation of light in the waveguide core can be efficiently coupled to the optoelectronic component. The distance is optionally less than 0,75-times, further optionally less than half, further optionally less than 0.45-times, the extension of the optoelectronic component on an axis parallel to the measurement direction. The distance is optionally more than 0.02-times, further optionally more than 0.1-times, further optionally more than 0.2-times, the extension of the optoelectronic component on an axis parallel to the measurement direction. Optionally, the reflection plane comprises a point that has a distance from all points of the waveguide core in the emitting structure, which distance is measured in a measurement direction in the waveguide core plane and orthogonally to the propagation direction of light in each respective point of the waveguide core in the emitting structure, wherein the distance is less than half the extension of the optoelectronic component in the measurement direction.

In case there is provided for a reflection plane, which is non-parallel to the waveguide core, optionally, the optoelectronic component extends to the side of the reflection plane which faces away from the waveguide core. Optionally, the optoelectronic component extends outside of an area delimited by the reflection layer and/or the trench(es) in at least one direction. In particular, the optoelectronic component extends further in a direction away from the waveguide core than the reflection plane.

Optionally, the reflection layer intersects with the waveguide core plane. I.e., optionally, the reflection layer reaches at least to the waveguide core plane, and further optionally reaches below the waveguide core plane. Taking into the account the non-zero extension of the waveguide core perpendicularly to the waveguide core plane, a lower waveguide core boundary plane may be defined which lies on the lower boundary/interface of the waveguide core, i.e. which is considered to be parallel to the waveguide core plane and which delimits the waveguide core in the direction of the optoelectronic component. Optionally, the reflection layer intersects with the lower waveguide core boundary plane. I.e., optionally, the reflection layer reaches at least to the lower waveguide core boundary plane, and further optionally reaches below the lower waveguide core boundary plane. Optionally, the reflection layer ends above a plane, in which a top surface of the optoelectronic component is provided and which is parallel to the waveguide core plane; i.e., optionally, the reflection layer does not reach to said plane. However, optionally the reflection layer reaches to the plane, in which the top surface of the optoelectronic component is provided and which is parallel to the waveguide core plane. In particular, the plane may be a top surface of the substrate supporting the optoelectronic component. With the reflection layer reaching to the waveguide core plane (and, therefore, the level of the emitting structure) or even to the optoelectronic component, a higher fraction light emitted from the emitting structure can be reflected to the optoelectronic component. The reflection layer may even reach below the plane, in which the top surface of the optoelectronic component is provided.

Optionally, there is provided for at least one trench in the cladding material, wherein the reflection layer is at least partially provided on a side face of the trench. By providing for a trench, the reflection layer can easily be deposited in a reflection plane that intersects with the waveguide core plane. Optionally, at least the side face of the trench, on which the reflection layer is at least partially provided, is substantially orthogonal to the waveguide core plane. Trench refers to the cladding material continuing on both sides of the trench. **I.e.,** the cladding material is contiguous to a first side face of the trench and to a second side face of the trench opposite the first side face. The trench in particular has the form of a recess or gap in the cladding material.

Optionally, the at least one trench extends into the cladding material at least to the level of the waveguide core plane and further optionally extends into the cladding material at least to the lower waveguide core boundary plane, further optionally the at least one trench extends below the waveguide core plane and/or the lower waveguide core boundary plane. Optionally, also the reflection layer on the side face of the at least one trench extends at least to the level of the waveguide core plane. Thus, light emitted from the emitting structure approximately in the waveguide core plane can be reflected by the reflection layer.

Optionally, the at least one trench penetrates through the cladding material at least in sections. Optionally, the at least one trench reaches to a plane, in which a top surface of the optoelectronic component is provided and which is parallel to the waveguide core plane, and further optionally reaches below said plane. Optionally, the at least one trench penetrates through the waveguide core. Optionally, the at least one trench penetrates through a material, which is contiguous with the waveguide core and which is the same material that the waveguide core comprises, in particular if a rib-waveguide is used. Optionally, the at least one trench or a further trench is arranged on a further side of the emitting structure with respect to the direction of propagation of light in the waveguide core in the emitting structure. I.e., optionally, the emitting structure is provided between the trench(es). In the case of a further trench, the reflection layer is also at least partially provided on a side face of the further trench. Optionally, the at least one trench or another further trench connects the trench(es) on the sides of the emitting structure. Optionally, there is provided for a trench displaced from the emitting structure in the direction of propagation of light in the waveguide core in the emitting structure. Optionally, there is provided at least for a first trench and a second trench (which may be interconnected), wherein the side face of the first and the second trench, which respectively comprise parts of the reflection layer, enclose an angle of between 10° and 170°, in particular substantially 90°, measured in the waveguide core plane and on the side facing the optoelectronic component. Optionally, there is provided for a third trench (which may be interconnected with the second trench), wherein the side face of the second and the third trench enclose an angle of between 10° and 170°, in particular substantially 90°, measured in the waveguide core plane and on the side facing the optoelectronic component. The trench(es) surround(s) at least one point of the emitting structure optionally by at least 180°, further optionally by at least 270°, as measured in the waveguide core plane. (I.e., there is at least one point of the emitting structure, wherein an angular range around said point in the waveguide core plane is covered by the trench(es) by optionally at least 180°, further optionally by at least 270°. Optionally, this condition holds for every point of the emitting structure.) Thus, the emitting structure can be substantially confined by the trench and in particular by the reflection layer, resulting in low losses of light emitted from the emitting structure.

Optionally, the trench (wherein a plurality of interconnected trenches is considered as one trench) comprises a section which has one of the following forms in a cross-section through a plane parallel to the waveguide core plane:
- rectangular with an opening in one side of the rectangle for the waveguide core;
- polygonal with an opening in one side of the polygon for the waveguide core;
- the form of a polygonal chain;
- circular with an opening for the waveguide core, in particular in the form of a circular arc with an angle of optionally more than 180°;
- the form of a funnel or cone, in particular with an acute angle.

The trench may be straight in a cross-section parallel to the waveguide core plane or it may be curved. The optoelectronic component may for example be rectangular or oval in a cross-section parallel to the waveguide core plane

Optionally, the reflection layer is arranged at least partially in a plane parallel to and displaced from the waveguide core plane in a direction away from the optoelectronic component. Thus, light emitted by the emitting structure in a direction away from the optoelectronic component is reflected by the reflection layer. Optionally, this reflection layer is arranged displaced from the waveguide core plane (orthogonally to the waveguide core plane) by more than 0.1 µm, further optionally by more than 0.5 µm, further optionally by more than 2 µm, and/or by less than 200 µm, further optionally by less than 50 µm, further optionally by less than 25 µm. Optionally, this reflection layer is arranged displaced from the waveguide core plane (orthogonally to the waveguide core plane) by more than 0.1-times, further optionally by more than 0.5-times, further optionally by more than 1-times, the distance of the waveguide core plane from the optoelectronic component (orthogonally to the waveguide core plane) and/or by less than 50-times, further optionally by less than 10-times, further optionally by less than 3-times, the distance of the waveguide core plane from the optoelectronic component (orthogonally to the waveguide core plane).

Optionally, the emitting structure is at least partially arranged between the reflection layer and the optoelectronic component.

Optionally, the emitting structure comprises a grating structure (that causes diffraction and/or scattering of the propagating light), in particular a diffraction grating and/or a scattering structure. Optionally, the period of the grating structure varies, in particular in the direction of the propagation of light in the waveguide core. Optionally, the emitting structure comprises a (widening) tapered section of the waveguide core, wherein the lateral width (perpendicular to a direction of propagation of light in the waveguide core and in the waveguide core plane) of the waveguide core increases in the (widening) tapered section in the direction of an end of the waveguide core. Optionally, the lateral width of the waveguide core is increased in the (widening) tapered section at least by 50 % of the lateral width prior to the tapered section and/or at least to a lateral width of 1 µm. Thus, light is deflected/scattered out of the emitting structure particularly efficiently.

Optionally the emitting structure comprises a (narrowing) tapered section of the waveguide core, wherein the lateral width of the waveguide core decreases in the (narrowing) tapered section towards an end of the waveguide core. Thus, light is deflected/scattered/emitted out of the emitting structure particularly efficiently with minimal back reflections into the waveguide core.

Optionally, the emitting structure comprises a grating structure (in particular a diffraction grating and/or a scattering structure) with a modulating lateral width and/or a modulating thickness. The thickness is measured orthogonally to the waveguide core plane. Thus, light is deflected/scattered out of the emitting structure particularly efficiently.

Optionally, the emitting structure comprises a section of the waveguide core with a plurality of holes in the waveguide core and/or with a plurality of disconnected segments of the waveguide core. These can cause scattering of light in the waveguide core. Thus, light is deflected/scattered out of the emitting structure particularly efficiently. The plurality of disconnected segments of the waveguide core are optionally provided as pillars, wherein the length extension of the pillars is in particular orthogonal to the waveguide core plane. The pillars have e.g. a square or circular cross section parallel to the waveguide core plane.

Optionally, the emitting structure comprises an end face of the waveguide core (i.e. an abrupt end, in particular without prior substantial variations in the lateral width of the waveguide core) in the direction of propagation of light in the waveguide core. Thus, light is emitted out of the emitting structure particularly efficiently. The end face is a face of the waveguide core, from which the cladding material lies in the direction of propagation of light in the waveguide core and which optionally is contiguous with cladding material in the direction of propagation of light. The end face optionally has an angle of between 30° and 135° with respect to the waveguide core plane. Further optionally, the end face is substantially orthogonal to the waveguide core plane. In particular, if the end face has an angle of between 30° and 60° with respect to the waveguide core plane and faces away from optoelectronic component, emitted light may be directed towards the optoelectronic component particularly efficiently by total internal reflection occurring at the end face.

Optionally the emitting structure comprises an inverted-tapered section of the waveguide core, wherein the lateral width of the waveguide core decreases (in particular significantly) below the wavelength, e.g. below 500 nm, and the optical mode field expands in diameter. This so-called inverted-taper allows for an emission at the end face with the advantage of a particularly low reflection back into the waveguide core.

Optionally, the emitting structure comprises an inwardly spiralling section of the waveguide core. I.e., the waveguide core is bent in a spiral, wherein the spiral extends in the waveguide core plane. Therein, light is lost due to insufficient confinement. Thus, light is emitted particularly efficiently.

Optionally, the emitting structure comprises at least one scattering element displaced from the waveguide core in a direction orthogonally to the waveguide core plane and/or in a direction orthogonally to the direction of propagation of light in the waveguide core plane. The scattering elements can scatter light out of the waveguide core in the emitting structure by interfering with the evanescent field of light guided in the waveguide core.

The reflection layer may comprise more than one (distinct) layer. There may be provided for additional layers above the emitting structure.

Referring to the method for producing the photonic integrated circuit, optionally, at least a part of the reflection layer is provided in a reflection plane, which reflection plane intersects with the waveguide core plane.

Optionally, the reflection plane is provided on a side of the emitting structure with respect to a propagation direction of light in the waveguide core in the emitting structure.

Optionally, the reflection plane has a distance from the emitting structure of the waveguide core, which distance is measured in a measurement direction in the waveguide core plane and orthogonally to the propagation direction of light in the waveguide core in the emitting structure, wherein the distance is less than the extension of the optoelectronic component on an axis parallel to the measurement direction.

Optionally, the method comprises:
- forming at least one trench in the cladding material by selectively removing parts (in particular with one or more of the subtractive methods as described above) of, preferably etching into, the cladding material preferably at least to the level of the waveguide core plane, wherein the reflection layer is at least partially provided by a side face of the trench. The trench is optionally realized by applying a patterned etch mask by means of photolithography and a reactive ion etching process. Subsequently, the etch mask may be removed chemically. The steps of the method may be conducted in any order. In particular, the at least one trench is optionally formed in the cladding material prior to providing for the reflection layer.

Optionally, the step of forming the trench in the cladding material comprises:
(completely) penetrating through the cladding material and optionally reaching to a plane, in which a top surface of the optoelectronic component is provided and which is parallel to the waveguide core plane.

Optionally, the method further comprises the step:
- applying the reflection layer at least partially in the at least one trench and/or
- arranging the reflection layer at least partially in a plane parallelly displaced from the waveguide core plane in a direction away from the optoelectronic component.

By way of example, the disclosure is further explained with respect to some selected embodiment shown in the drawings. However, these embodiments shall not be considered limiting for the disclosure.
Fig. 1 schematically shows an embodiment of the photonic integrated circuit.
Fig. 2 schematically shows an exploded view of the embodiment of Fig. 1.
Fig. 3 schematically shows another embodiment of the photonic integrated circuit.
Fig. 4 schematically shows an exploded view of the embodiment of Fig. 3.
Fig. 5 schematically shows a sectional view of the embodiment of Fig. 3.
Fig. 6 schematically shows another embodiment of the photonic integrated circuit.
Fig. 7 schematically shows another embodiment of the photonic integrated circuit in a top view.
Fig. 8 schematically shows another embodiment of the photonic integrated circuit comprising two waveguide cores and optoelectronic components.

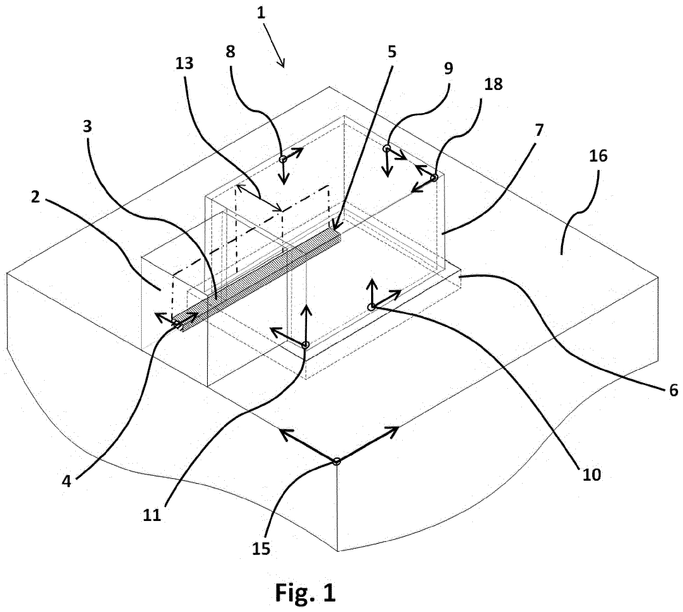

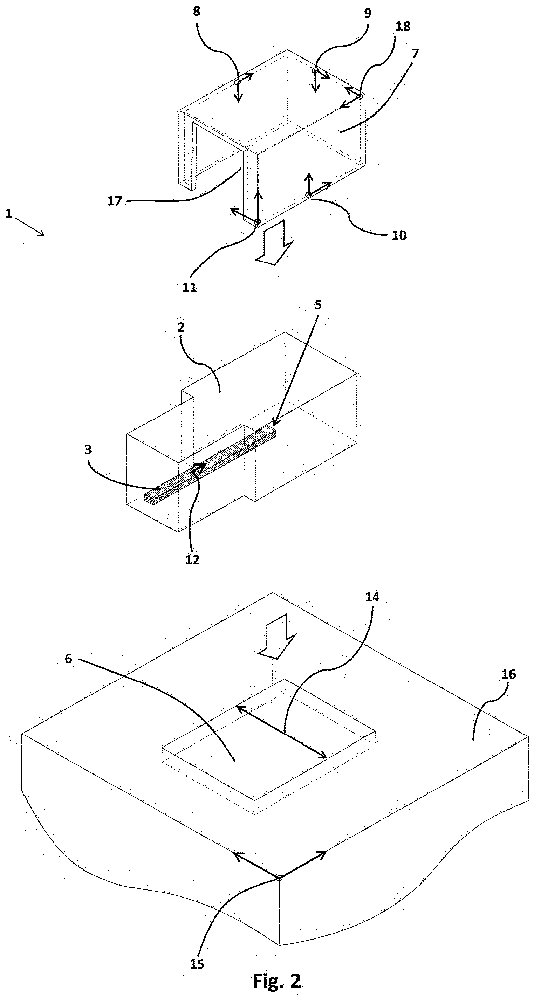

Fig. 1 shows an embodiment of the photonic integrated circuit 1. Fig. 2 shows the same embodiment of the PIC 1 in an exploded view. The PIC 1 comprises a cladding material 2 and a waveguide core 3 in the cladding material 2. The waveguide core 3 extends in a waveguide core plane 4 (indicated by two arrows spanning the waveguide core plane 4). The waveguide core 3 comprises an emitting structure 5 for deflecting and/or scattering and/or emitting light out of the waveguide core 3. The PIC 1 further comprises an optoelectronic component 6 arranged displaced from the waveguide core plane 4. The optoelectronic component 6 is in particular a photodiode and is arranged essentially below the waveguide core 2, in particular below the emitting structure 5 of the waveguide core 3. In the present embodiment, the emitting structure 5 comprises an end face of the waveguide core 3. However, various different emitting structures 5, in particular also the emitting structures 5 described in this disclosure, are possible and compatible with the present embodiment, as well as with the embodiments described later.

The PIC 1 further comprises a reflection layer 7 for reflecting light emitted from the emitting structure 5 to the optoelectronic component 6. Parts of the reflection layer 7 are provided in one of four reflection planes 8, 9, 10, 11 (which are each indicated by two arrows spanning the respective reflection plane 8, 9, 10, 11). The reflection planes 8, 9, 10, 11 each intersect with the waveguide core plane 4 and in particular are each orthogonal to the waveguide core plane 4. In particular, the reflection planes 8, 9, 10, 11 delimit between their intersection lines the lateral surface of a prism, in particular of a cuboid. One of the reflection planes 8, 9, 10, 11 (in particular reflection plane 8) is provided on a first side of the emitting structure 5 with respect to a propagation direction 12 of light (indicated by an arrow) in the waveguide core 3 in the emitting structure 5. Another one of the reflection planes 8, 9, 10, 11 (in particular reflection plane 10) is provided on the second side of the emitting structure 5 with respect to the propagation direction 12 of light in the waveguide core 3 in the emitting structure 5.

The two reflection planes 8, 10 lying on sides of the emitting structure 5 each have a distance 13 from the emitting structure 5 of the waveguide core 3, which distance 13 is measured in a measurement direction (parallel to 13) in the waveguide core plane 4 and orthogonally to the propagation direction 12 of light in the waveguide core 3 in the emitting structure 5. The distance 13 is less than the extension 14 (see lowest part of Fig. 2) of the optoelectronic component 6 on an axis parallel to the measurement direction (and, therefore, parallel to 13), and in this embodiment even less than half of said extension.

The parts of the reflection layer 7 on the reflection planes 8, 9, 10, 11 each intersect with the waveguide core plane 3 and reach to a plane 15 (indicated by two arrows spanning the plane 15), in which a top surface of the optoelectronic component 6 is provided and which is parallel to the waveguide core plane 4. In particular, the parts of the reflection layer 7 on the reflection planes 8, 9, 10, 11 border on the plane 15. The optoelectronic component 6 is supported by and partially embedded in a substrate 16. A top surface of the substrate 16 is at the same level as the top surface of the optoelectronic component 6. Therefore, also the top surface of the substrate 16 is provided in the plane 15. The part of the reflection layer 7 on the reflection 11 includes an opening 17, through which the waveguide core 3 enters into the area in the waveguide core plane delimited by the reflection planes 8, 9, 10, 11. The optoelectronic component 6 extends outside of the area delimited by the reflection planes 8, 9, 10, 11 (parallelly to the waveguide core plane). In particular, the optoelectronic component's 6 extension perpendicularly to the reflection planes 8, 10 is larger than the distance between the two reflection planes 8, 10 and the optoelectronic component's 6 extension perpendicularly to the reflection planes 9, 11 (i.e. substantially the direction 12 of propagation of light in the emitting structure in the waveguide core 3) is larger than the distance between the two reflection planes 9, 11.

A part of the reflection layer 7 is further arranged in a plane 18 (indicated by two arrows spanning the plane) parallel to the waveguide core plane 4 and displaced from the waveguide core plane 4 in a direction away from the optoelectronic component 6. The emitting structure 5 is arranged between the reflection layer 7 and the optoelectronic component 6. Thus, the reflection layer 7 essentially surrounds and confines the emitting structure 5 in all directions but the one in which the optoelectronic component 6 and the substrate 16 lie (and neglecting the opening 17). Thus, a particularly high fraction of the light emitted from the emitting structure 5 can be directed to the optoelectronic component 6, substantially regardless of the direction in which the light is emitted from the emitting structure 5. Furthermore, cross talk to potential further optoelectronic components can be reduced or prevented.

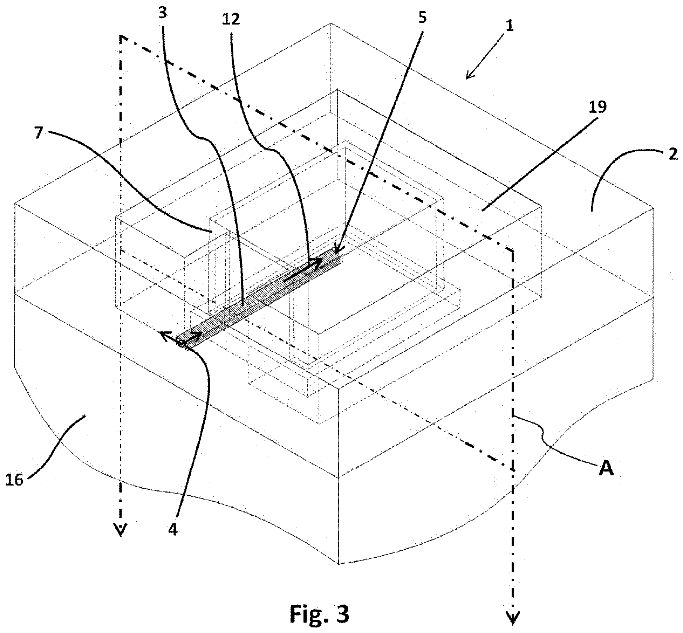

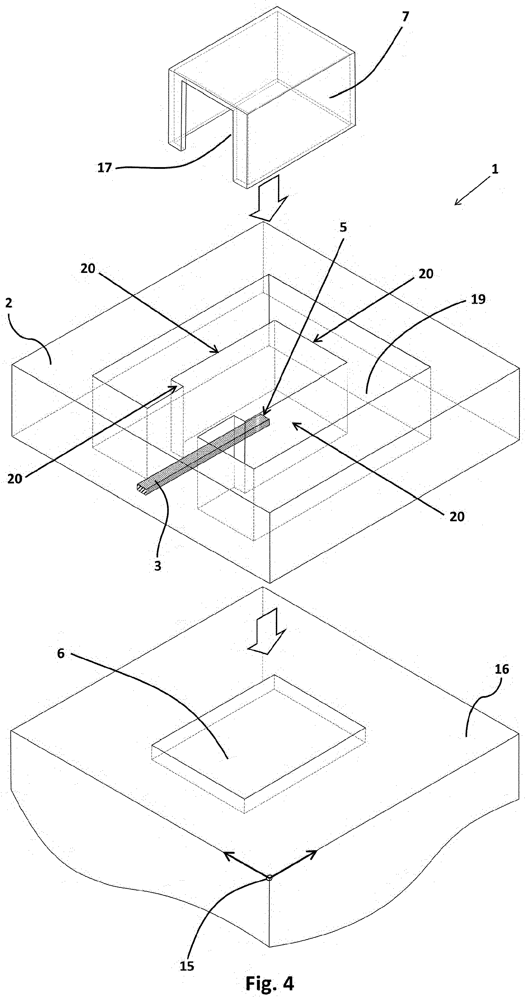

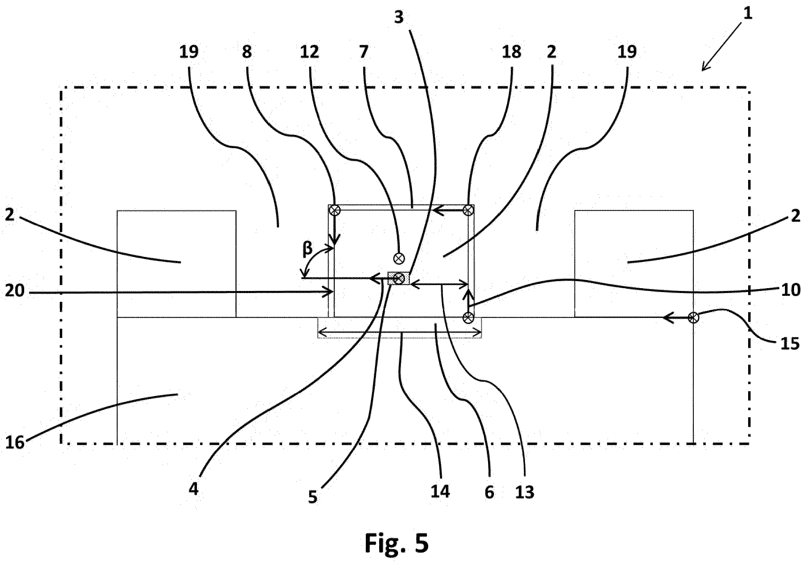

Fig. 3 shows another embodiment of the PIC 1. Fig. 4 shows the same embodiment of the PIC 1 in an exploded view. Fig. 5 shows the same embodiment of the PIC 1 in a sectional view through plane A indicated in Fig. 3. This embodiment is similar to the one described in the context of Fig. 1. Therefore, similar elements and elements serving similar functions are indicated by the same reference numerals as in Fig. 1. The embodiment of Fig. 3 differs from the one illustrated in Fig. 1 mostly in that there is provided for a trench 19 in the cladding material 2, i.e. the cladding material 2 continues on both sides of the trench 19. The reflection layer 7 is partially provided on a side face 20 of the trench 19. In particular, the side face 20 lies on the reflection planes 8, 9, 10, 11 already described in the context of the embodiment of Fig. 1. Again, the reflection planes 8, 9, 10, 11 are each perpendicular to the waveguide core plane 4. I.e., e.g. reflection plane 8 has an angle β of substantially 90° with respect to the waveguide core plane 4. Furthermore, and similar to the embodiment of Fig. 1, a part of the reflection layer 7 is arranged in a plane 18 parallel to the waveguide core plane 4 and displaced from the waveguide core plane.

The trench 19 extends into the cladding material 2 through the level of the waveguide core plane 4. In particular, the trench 19 penetrates (completely) through the cladding material 2 and reaches to the plane 15, in which the top surface of the optoelectronic component 6 is provided and which is parallel to the waveguide core plane 4.

The trench is arranged on both sides of the emitting structure with respect to the direction 12 of propagation of light in the waveguide core 3 in the emitting structure 5. Further, the trench 12 also connects the two sections at the side of the emitting structure 5 at the back side and partially extends at the front side, leaving an opening 17 in the trench 12, i.e. a section where the cladding material 2 remains and is not removed. Thereby, the trench surrounds the emitting structure 5 in the waveguide core plane 4 with the exception of the opening 17 for the waveguide core 3 in one direction.

The waveguide core plane 4 is indicated in Fig. 5 by an arrow orthogonal to the drawing plane (and therefore the plane A of the sectional view) and another arrow, which together span the waveguide core plane 4. In this view, also the propagation direction 12 of light in the waveguide core 3 in the emitting structure 5 is orthogonal to the drawing plane and the plane A.

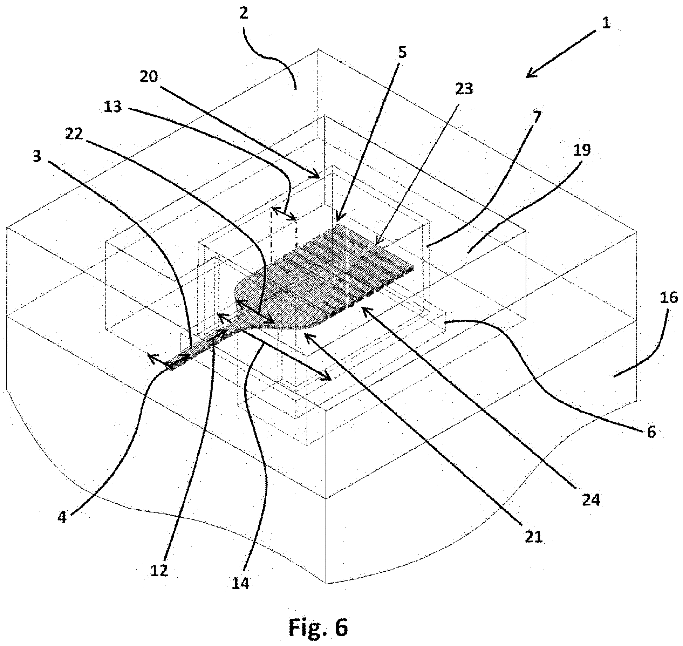

Fig. 6 shows another embodiment of the PIC 1, similar to the one illustrated in Fig. 3. Similar elements and elements serving similar functions are indicated by the same reference numerals as in Fig. 3. However, this embodiment differs in the design of the emitting structure 5. In this embodiment, the emitting structure 3 comprises a (widening) tapered section 21 of the waveguide-core 3, in which the lateral width 22 of the waveguide core 3 increases in the direction of an end 23 of the waveguide core 3. The lateral width 22 of the waveguide core 2 is measured orthogonally to the direction 12 of propagation of light in the waveguide core 2. Subsequently (i.e. closer to the end 23 of the waveguide core 3) the emitting structure 3 comprises a grating structure 24.

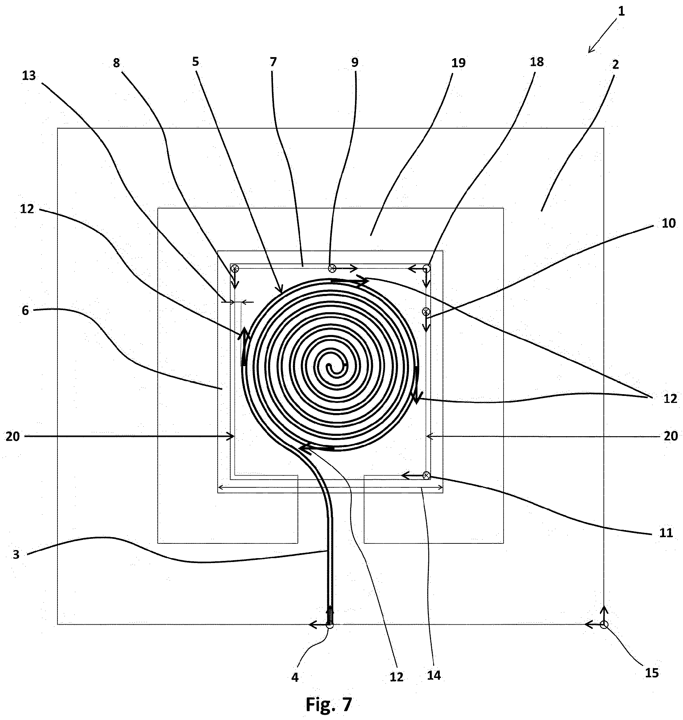

Fig. 7 another embodiment of the photonic integrated circuit 1 in a top view. This embodiment is similar to the one shown in Fig. 6 and similar elements or elements serving similar functions are indicated by the same reference numerals. This embodiment differs from the one illustrated in Fig. 3 in that the emitting structure 5 comprises an inwardly spiralling section of the waveguide core 3.

Furthermore, Fig. 7 illustrates the definition of the propagation direction 12 of light in the waveguide core 3 in the emitting structure 5, in particular in the context of a waveguide core 3 comprising a section which is not straight. Therein, the direction 12 of propagation of light in the waveguide core 3 in the emitting structure 5 is variable and is the propagation direction 12 in a respective point of the waveguide core 3. In Fig. 7, four examples of points of the waveguide core 3 and the respective propagation direction 12 in each of these points are illustrated. Reference to configurations relative to the propagation direction 12 of the waveguide core 3 in the emitting structure 5 refers to that there is at least one point of the waveguide core 3 in the emitting structure for which said relative configuration is satisfied. Optionally, said relative configuration applies for all points of the waveguide core 3 in the emitting structure 5.

The reflection planes 8, 10 are each provided on a side of the emitting structure 5 with respect to the propagation direction 12 of light in the waveguide core 3 in the emitting structure 5 at the points on the left and right side of the emitting structure 5. The reflection planes 9, 11 are each provided on a side of the emitting structure 5 with respect to the propagation direction 12 of light in the waveguide core 3 in the emitting structure 5 at the point in the lower and upper side (in the drawing, i.e. rearward and forward side) of the emitting structure 5.

The reflection plane 8 has a distance 13 from the emitting structure 5 of the waveguide core 3, which distance 13 is measured in a measurement direction in the waveguide core plane 4 and orthogonally to the propagation direction 12 of light in the waveguide core 3 in the emitting structure 5, wherein the distance 13 is less than the extension 14 of the optoelectronic component 6 on an axis parallel to the measurement direction. This means that the reflection plane 8 comprises a point that has a distance 12 from a point (at least one point) of the waveguide core 3 in the emitting structure 5, which distance 12 is measured in a measurement direction in the waveguide core plane 4 and orthogonally to the propagation direction 12 of light in said point of the waveguide core 3 in the emitting structure 5, wherein the distance 12 is less than the extension 14 of the optoelectronic component 6 in the measurement direction. The distance 13 is illustrated for one such point of the waveguide core 3 in the emitting structure 5. In particular, the distance 13 indicated in Fig. 7 is less than a tenth of the extension 14 of the optoelectronic component 6. Furthermore, in this embodiment, the reflection planes 9, 10, 11 each also have a distance 13 from the emitting structure 5 of the waveguide core 3, which distance 13 is measured in a measurement direction in the waveguide core plane 4 and orthogonally to the propagation direction 12 of light in the waveguide core 3 in the emitting structure 5, wherein the distance 13 is less than the extension 14 of the optoelectronic component 6 on an axis parallel to the measurement direction. For example, this distance relation is satisfied concerning the reflection plane 9 for the upper point for which the propagation direction is indicated. For the reflection plane 10, the distance relation is e.g. satisfied for the right point and for the reflection plane 11 it is e.g. satisfied for the lower point. Thus, light emitted from the waveguide core 3 in the emitting structure 5 is particularly efficiently trapped within the trench 19 and guided to the optoelectronic component 6.

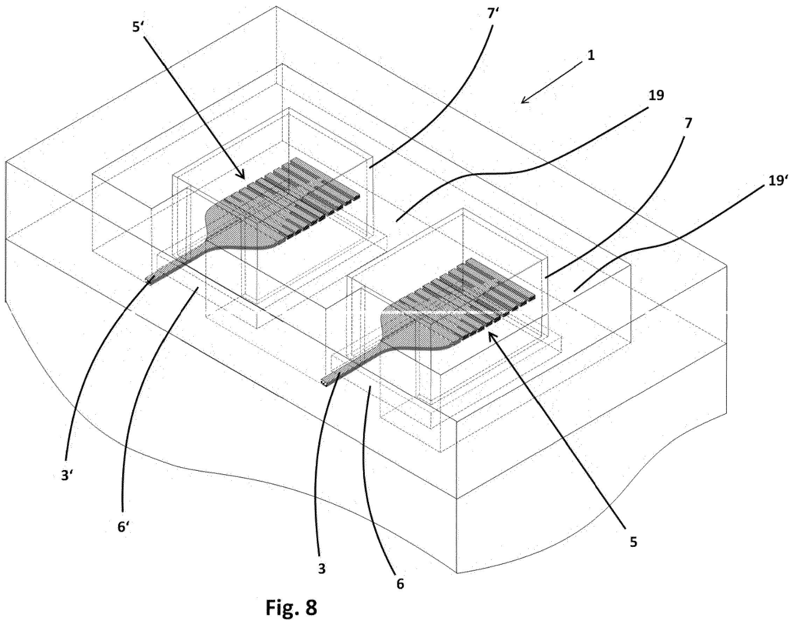

Fig. 8 schematically shows another embodiment of the photonic integrated circuit 1. In this embodiment, the photonic integrated circuit 1 is configured to couple light from a first and a second waveguide core 3, 3', each with a respective emitting structure 5, 5', to a respective first and second optoelectronic component 6, 6'. Each of the waveguide cores 3, 3', the emitting structure 5, 5' and the optoelectronic components 6, 6' is similar to the waveguide core 3, the emitting structure 5 and the optoelectronic component 6, respectively, shown and described in the context of Fig. 6.

For an integrated circuit 1, wherein light from different emitting structures 5, 5' is to be coupled to different optoelectronic components 6, 6', it is important to limit cross-talk between the couplings, i.e. to prevent light emitted from the first emitting structure 5 to be coupled to the second optoelectronic component 6' (which is associated with the second emitting structure 5') and to prevent light emitted from the second emitting structure 5' to be coupled to the first optoelectronic component 6.

For this purpose, the first emitting structure 5 is partially surrounded by a first reflection layer 7 and the second emitting structure 5' is partially surrounded by a second reflection layer 7' (each similar to the embodiment shown in Fig. 6). The reflection layers 7, 7' are provided in a trench 19, 19', which are provided partially surrounding the respective emitting structure 5, 5'. Each trench 19, 19' is similar to the trench 19 of Fig. 6, however the trenches 19, 19' are connected between first and the second emitting structure 5, 5' and therefore form one larger trench, which makes the fabrication of the trenches 19, 19' easier. The first reflection layer 7 prevents light emitted from the first emitting structure 5 from reaching the second optoelectronic component 6' and the second reflection layer 7' prevents light emitted from the second emitting structure 5' from reaching the first optoelectronic component 6.

The photonic integrated circuit may of course comprise further waveguide cores and emitting structures for coupling light to further respective optoelectronic components, wherein preferably also the further emitting structures are at least partially surrounded by respective further reflection layers.

## Claims

1. Photonic integrated circuit (1), comprising:
- a cladding material (2);
- a waveguide core (3) in the cladding material (2), extending in a waveguide core plane (4) and comprising an emitting structure (5) for deflecting and/or scattering and/or emitting light out of the waveguide core (3);
- an optoelectronic component (6) arranged displaced from the waveguide core plane (4), wherein the emitting structure (5) of the waveguide core (3) is characterised as the section or a fraction of the section of the waveguide core (3) which is congruent with the optoelectronic component (6) when shifted parallelly perpendicularly to the waveguide core plane (4);
- a reflection layer (7) for reflecting light emitted from the emitting structure (5) to the optoelectronic component (6);
wherein at least a part of the reflection layer (7) is provided in a reflection plane (8, 9, 10, 11), which reflection plane (8, 9, 10, 11) intersects with the waveguide core plane (4), **characterized in that**
the reflection plane (8, 9, 10, 11) is provided on a side of the emitting structure (5) with respect to a propagation direction (12) of light in the waveguide core (3) in the emitting structure (5) such that light that is emitted by the emitting structure (5) in a sideways direction can be reflected by the reflection layer (7).

2. Photonic integrated circuit (1) according to claim 1, **characterized in that** the reflection layer (7) comprises a different material than the cladding material (2) and/or
the reflection layer (7) comprises a metal, in particular aluminium, and/or a dielectric material, which dielectric material preferably has a refractive index at least 2-times the refractive index of the cladding material (2), in particular amorphous silicon.

3. Photonic integrated circuit (1) according to claim 1 or 2, **characterized in that** the reflection plane (8, 9, 10, 11) has a distance (13) from the emitting structure (5) of the waveguide core (3), which distance is measured in a measurement direction in the waveguide core plane (4) and orthogonally to the propagation direction (12) of light in the waveguide core (3) in the emitting structure (5), wherein the distance (13) is less than the extension (14) of the optoelectronic component (6) on an axis parallel to the measurement direction.

4. Photonic integrated circuit (1) according to any one of the preceding claims, **characterized in that** the reflection layer (7) intersects with the waveguide core plane (4) and optionally reaches to a plane (15), in which a top surface of the optoelectronic component (6) is provided and which is parallel to the waveguide core plane (4).

5. Photonic integrated circuit (1) according to any one of the preceding claims, **characterized in that** there is provided for at least one trench (19) in the cladding material (2), wherein the reflection layer (7) is at least partially provided on a side face (20) of the trench (19).

6. Photonic integrated circuit (1) according to claim 5, **characterized in that** the at least one trench (19) extends into the cladding material (2) at least to the level of the waveguide core plane (4) and/or
the at least one trench (19) penetrates through the cladding material (2) at least in sections and optionally reaches to a plane (15), in which a top surface of the optoelectronic component (6) is provided and which is parallel to the waveguide core plane (4).

7. Photonic integrated circuit (1) according to any one of the claims 5 or 6, **characterized in that** the at least one trench (19) or a further trench is arranged on a further side of the emitting structure (5) with respect to the propagation direction (12) of light in the waveguide core (3) in the emitting structure (5).

8. Photonic integrated circuit (1) according to any one of the preceding claims, **characterized in that** the reflection layer (7) is arranged at least partially in a plane (18) parallel to and displaced from the waveguide core plane (4) in a direction away from the optoelectronic component (6).

9. Photonic integrated circuit (1) according to any one of the previous claims, **characterized in that** the emitting structure (5) comprises a grating structure (24), and the emitting structure (5) optionally further comprises a widening tapered section (21) of the waveguide core (3), wherein the lateral width (22) of the waveguide core (3) increases in the widening tapered section (21) in the direction of an end (23) of the waveguide core (3).

10. Photonic integrated circuit (1) according to any one of the previous claims **characterized in that** the emitting structure (5) comprises a narrowing tapered section of the waveguide core (3), wherein the lateral width (22) of the waveguide core (3) decreases in the narrowing tapered section towards an end (23) of the waveguide core (3).

11. Photonic integrated circuit (1) according to any one of the previous claims, **characterized in that** the emitting structure (5) comprises a grating structure with a modulating lateral width and/or a modulating thickness.

12. Photonic integrated circuit (1) according to any one of the previous claims, **characterized in that** the emitting structure (5) comprises an inwardly spiralling section of the waveguide core (3).

13. Photonic integrated circuit (1) according to any one of the previous claims, **characterized in that** the emitting structure (5) comprises a section of the waveguide core (3) with a plurality of holes in the waveguide core (3) and/or with a plurality of disconnected segments of the waveguide core (3).

14. Method for producing a photonic integrated circuit (1) comprising the steps of:
- providing for a cladding material (2) with a waveguide core (3) in the cladding material (2), the waveguide core (3) extending in a waveguide core plane (4) and comprising an emitting structure (5) for deflecting and/or scattering and/or coupling light out of the waveguide core (3) and emitting the light, and providing for an optoelectronic component (6) arranged displaced from the waveguide core plane (4), wherein the emitting structure (5) of the waveguide core (3) is characterised as the section or a fraction of the section of the waveguide core (3) which is congruent with the optoelectronic component (6) when shifted parallelly perpendicularly to the waveguide core plane (4);
- providing for a reflection layer (7) for reflecting light emitted from the emitting structure (5) to the optoelectronic component (6), wherein at least a part of the reflection layer (7) is provided in a reflection plane (8, 9, 10, 11), which reflection plane (8, 9, 10, 11) intersects with the waveguide core plane (4), wherein the reflection plane (8, 9, 10, 11) is provided on a side of the emitting structure (5) with respect to a propagation direction (12) of light in the waveguide core (3) in the emitting structure (5) such that light that is emitted by the emitting structure (5) in a sideways direction can be reflected by the reflection layer (7).

15. Method according to claim 14, **characterized in that** the method comprises:
- forming at least one trench (19) in the cladding material (2) by selectively removing parts of, preferably etching into, the cladding material (2) preferably at least to the level of the waveguide core plane (4), wherein the reflection layer (7) is at least partially provided by a side face (20) of the trench (19).

## Patentansprüche

1. Photonik-integrierte Schaltung (1), aufweisend:
- ein Mantelmaterial (2);
- einen Wellenleiterkern (3) im Mantelmaterial (2), der sich in einer Wellenleiterkernebene (4) erstreckt und eine Emissionsstruktur (5) aufweist zum Ablenken und/oder Streuen und/oder Auskoppeln von Licht aus dem Wellenleiterkern (3);
- eine optoelektronische Komponente (6), angeordnet versetzt zur Wellenleiterkernebene (4), wobei die Emissionsstruktur (5) des Wellenleiterkerns (3) als der Abschnitt oder ein Bruchteil des Abschnitts des Wellenleiterkerns (3) charakterisiert ist, welcher kongruent mit der optoelektronischen Komponente (6) ist, wenn er parallel senkrecht zur Wellenleiterkernebene (4) verschoben wird;
- eine Reflexionsschicht (7) zum Reflektieren von Licht, das von der Emissionsstruktur (5) zur optoelektronischen Komponente (6) emittiert wird; wobei zumindest ein Teil der Reflexionsschicht (7) in einer Reflexionsebene (8, 9, 10, 11) vorgesehen ist, welche Reflexionsebene (8, 9, 10, 11) sich mit der Wellenleiterkernebene (4) schneidet,
**dadurch gekennzeichnet, dass** die Reflexionsebene (8, 9, 10, 11) auf einer Seite der Emissionsstruktur (5) bezüglich einer Ausbreitungsrichtung (12) von Licht im Wellenleiterkern (3) in der Emissionsstruktur (5) vorgesehen ist, sodass Licht, das von der Emissionsstruktur (5) seitwärts emittiert wird, von der Reflexionsschicht (7) reflektiert werden kann.

2. Photonik-integrierte Schaltung (1) nach Anspruch 1, **dadurch gekennzeichnet, dass** die Reflexionsschicht (7) ein anderes Material als das Mantelmaterial (2) aufweist und/oder
die Reflexionsschicht (7) ein Metall aufweist, insbesondere Aluminium, und/oder ein dielektrisches Material, welches dielektrische Material vorzugsweise einen Brechungsindex aufweist, der mindestens 2-mal so groß ist wie der Brechungsindex des Mantelmaterials (2), insbesondere amorphes Silizium.

3. Photonik-integrierte Schaltung (1) nach Anspruch 1 oder 2, **dadurch gekennzeichnet, dass** die Reflexionsebene (8, 9, 10, 11) einen Abstand (13) von der Emissionsstruktur (5) des Wellenleiterkerns (3) aufweist, welcher Abstand in einer Messrichtung in der Wellenleiterkernebene (4) und orthogonal zur Ausbreitungsrichtung (12) von Licht im Wellenleiterkern (3) in der Emissionsstruktur (5) gemessen wird, wobei der Abstand (13) kleiner ist als die Ausdehnung (14) der optoelektronischen Komponente (6) auf einer Achse parallel zur Messrichtung.

4. Photonik-integrierte Schaltung (1) nach einem der vorhergehenden Ansprüche, **dadurch gekennzeichnet, dass** die Reflexionsschicht (7) sich mit der Wellenleiterkernebene (4) schneidet und optional bis zu einer Ebene (15) reicht, in welcher eine Oberseite der optoelektronischen Komponente (6) vorgesehen ist und die parallel zur Wellenleiterkernebene (4) ist.

5. Photonik-integrierte Schaltung (1) nach einem der vorhergehenden Ansprüche, **dadurch gekennzeichnet, dass** zumindest ein Graben (19) im Mantelmaterial (2) vorgesehen ist, wobei die Reflexionsschicht (7) zumindest teilweise an einer Seitenfläche (20) des Grabens (19) vorgesehen ist.

6. Photonik-integrierte Schaltung (1) nach Anspruch 5, **dadurch gekennzeichnet, dass** der zumindest eine Graben (19) sich in das Mantelmaterial (2) zumindest bis zur Höhe der Wellenleiterkernebene (4) erstreckt und/oder
der zumindest eine Graben (19) das Mantelmaterial (2) zumindest abschnittsweise durchdringt und optional bis zu einer Ebene (15) reicht, in welcher eine Oberseite der optoelektronischen Komponente (6) vorgesehen ist und die parallel zur Wellenleiterkernebene (4) ist.

7. Photonik-integrierte Schaltung (1) nach einem der Ansprüche 5 oder 6, **dadurch gekennzeichnet, dass** der zumindest eine Graben (19) oder ein weiterer Graben auf einer weiteren Seite der Emissionsstruktur (5) bezüglich der Ausbreitungsrichtung (12) von Licht im Wellenleiterkern (3) in der Emissionsstruktur (5) angeordnet ist.

8. Photonik-integrierte Schaltung (1) nach einem der vorhergehenden Ansprüche, **dadurch gekennzeichnet, dass** die Reflexionsschicht (7) zumindest teilweise in einer Ebene (18) angeordnet ist, welche parallel und in einer Richtung weg von der optoelektronischen Komponente (6) versetzt zur Wellenleiterkernebene (4) ist.

9. Photonik-integrierte Schaltung (1) nach einem der vorhergehenden Ansprüche, **dadurch gekennzeichnet, dass** die Emissionsstruktur (5) eine Gitterstruktur (24) aufweist, und die Emissionsstruktur (5) optional ferner einen sich erweiternden konischen Abschnitt (21) des Wellenleiterkerns (3) aufweist, wobei die laterale Breite (22) des Wellenleiterkerns (3) sich in dem sich erweiternden konischen Abschnitt (21) in Richtung eines Endes (23) des Wellenleiterkerns (3) vergrößert.

10. Photonik-integrierte Schaltung (1) nach einem der vorhergehenden Ansprüche, **dadurch gekennzeichnet, dass** die Emissionsstruktur (5) einen sich verjüngenden konischen Abschnitt des Wellenleiterkerns (3) aufweist, wobei die laterale Breite (22) des Wellenleiterkerns (3) sich in dem sich verjüngenden konischen Abschnitt zu einem Ende (23) des Wellenleiterkerns (3) hin verkleinert.

11. Photonik-integrierte Schaltung (1) nach einem der vorhergehenden Ansprüche, **dadurch gekennzeichnet, dass** die Emissionsstruktur (5) eine Gitterstruktur mit modulierender lateraler Breite und/oder modulierender Dicke aufweist.

12. Photonik-integrierte Schaltung (1) nach einem der vorhergehenden Ansprüche, **dadurch gekennzeichnet, dass** die Emissionsstruktur (5) einen sich nach innen spiralförmig erstreckenden Abschnitt des Wellenleiterkerns (3) aufweist.

13. Photonik-integrierte Schaltung (1) nach einem der vorhergehenden Ansprüche, **dadurch gekennzeichnet, dass** die Emissionsstruktur (5) einen Abschnitt des Wellenleiterkerns (3) aufweist mit einer Vielzahl von Löchern im Wellenleiterkern (3) und/oder mit einer Vielzahl von voneinander getrennten Segmenten des Wellenleiterkerns (3).

14. Verfahren zum Herstellen einer photonik-integrierten Schaltung (1), aufweisend die Schritte:
- Bereitstellen eines Mantelmaterials (2) mit einem Wellenleiterkern (3) im Mantelmaterial (2), wobei sich der Wellenleiterkern (3) in einer Wellenleiterkernebene (4) erstreckt und eine Emissionsstruktur (5) aufweist zum Ablenken und/oder Streuen und/oder Auskoppeln von Licht aus dem Wellenleiterkern (3) und Emittieren des Lichts, und Bereitstellen einer optoelektronischen Komponente (6), angeordnet versetzt zur Wellenleiterkernebene (4), wobei die Emissionsstruktur (5) des Wellenleiterkerns (3) als der Abschnitt oder ein Bruchteil des Abschnitts des Wellenleiterkerns (3) charakterisiert ist, welcher kongruent mit der optoelektronischen Komponente (6) ist, wenn er parallel senkrecht zur Wellenleiterkernebene (4) verschoben wird;
- Bereitstellen einer Reflexionsschicht (7) zum Reflektieren von Licht, das von der Emissionsstruktur (5) zur optoelektronischen Komponente (6) emittiert wird, wobei zumindest ein Teil der Reflexionsschicht (7) in einer Reflexionsebene (8, 9, 10, 11) vorgesehen ist, welche Reflexionsebene (8, 9, 10, 11) sich mit der Wellenleiterkernebene (4) schneidet, wobei die Reflexionsebene (8, 9, 10, 11) auf einer Seite der Emissionsstruktur (5) bezüglich einer Ausbreitungsrichtung (12) von Licht im Wellenleiterkern (3) in der Emissionsstruktur (5) vorgesehen ist, so dass Licht, das von der Emissionsstruktur (5) seitwärts emittiert wird, von der Reflexionsschicht (7) reflektiert werden kann.

15. Verfahren nach Anspruch 14, **dadurch gekennzeichnet, dass** das Verfahren aufweist:
- Bilden mindestens eines Grabens (19) im Mantelmaterial (2) durch selektives Entfernen von Teilen des, vorzugsweise durch Ätzen in das, Mantelmaterial (2) vorzugsweise zumindest bis zur Höhe der Wellenleiterkernebene (4), wobei die Reflexionsschicht (7) zumindest teilweise durch eine Seitenfläche (20) des Grabens (19) vorgesehen ist.

## Revendications

1. Circuit intégré photonique (1), comprenant :
- un matériau de gaine (2) ;
- un cœur de guide d'onde (3) dans le matériau de gaine (2), s'étendant dans un plan de cœur de guide d'onde (4) et comprenant une structure émettrice (5) pour dévier et/ou diffuser et/ou émettre de la lumière hors du cœur de guide d'onde (3) ;
- un composant optoélectronique (6) disposé à distance du plan du cœur de guide d'onde (4), où la structure émettrice (5) du cœur de guide d'onde (3) est caractérisée comme la section ou une fraction de la section du cœur de guide d'onde (3) qui est congruente avec le composant optoélectronique (6) lorsqu'elle est déplacée parallèlement perpendiculairement au plan du cœur de guide d'onde (4) ;
- une couche de réflexion (7) pour réfléchir la lumière émise par la structure émettrice (5) vers le composant optoélectronique (6) ;
dans lequel au moins une partie de la couche de réflexion (7) est prévue dans un plan de réflexion (8, 9, 10, 11), lequel plan de réflexion (8, 9, 10, 11) intersecte le plan du cœur de guide d'onde (4),
**caractérisé en ce que**
le plan de réflexion (8, 9, 10, 11) est prévu sur un côté de la structure émettrice (5) par rapport à une direction de propagation (12) de la lumière dans le cœur de guide d'onde (3) dans la structure émettrice (5) de telle sorte que la lumière émise par la structure émettrice (5) dans une direction latérale puisse être réfléchie par la couche de réflexion (7).

2. Circuit intégré photonique (1) selon la revendication 1, **caractérisé en ce que** la couche de réflexion (7) comprend un matériau différent du matériau de gaine (2) et/ou
la couche de réflexion (7) comprend un métal, en particulier de l'aluminium, et/ou un matériau diélectrique, lequel matériau diélectrique présente de préférence un indice de réfraction au moins deux fois supérieur à l'indice de réfraction du matériau de gaine (2), en particulier du silicium amorphe.

3. Circuit intégré photonique (1) selon la revendication 1 ou 2, **caractérisé en ce que** le plan de réflexion (8, 9, 10, 11) a une distance (13) par rapport à la structure émettrice (5) du cœur de guide d'onde (3), laquelle distance est mesurée dans une direction de mesure dans le plan du cœur de guide d'onde (4) et orthogonalement à la direction de propagation (12) de la lumière dans le cœur de guide d'onde (3) dans la structure émettrice (5), où la distance (13) est inférieure à l'extension (14) du composant optoélectronique (6) sur un axe parallèle à la direction de mesure.

4. Circuit intégré photonique (1) selon l'une quelconque des revendications précédentes, **caractérisé en ce que** la couche de réflexion (7) intersecte le plan du cœur de guide d'onde (4) et peut éventuellement s'étendre jusqu'à un plan (15), dans lequel une surface supérieure du composant optoélectronique (6) est prévue et qui est parallèle au plan du cœur de guide d'onde (4).

5. Circuit intégré photonique (1) selon l'une quelconque des revendications précédentes, **caractérisé en ce qu'**il est prévu au moins une tranchée (19) dans le matériau de gaine (2), où la couche de réflexion (7) est au moins partiellement prévue sur une face latérale (20) de la tranchée (19).

6. Circuit intégré photonique (1) selon la revendication 5, **caractérisé en ce que** la au moins une tranchée (19) s'étend dans le matériau de gaine (2) au moins jusqu'au niveau du plan du cœur de guide d'onde (4) et/ou
la au moins une tranchée (19) traverse le matériau de gaine (2) au moins par sections et atteint éventuellement un plan (15), dans lequel une surface supérieure du composant optoélectronique (6) est prévue et qui est parallèle au plan du cœur de guide d'onde (4).

7. Circuit intégré photonique (1) selon l'une quelconque des revendications 5 ou 6, **caractérisé en ce que** la au moins une tranchée (19) ou une tranchée supplémentaire est disposée sur un autre côté de la structure émettrice (5) par rapport à la direction de propagation (12) de la lumière dans le cœur de guide d'onde (3) dans la structure émettrice (5).

8. Circuit intégré photonique (1) selon l'une quelconque des revendications précédentes, **caractérisé en ce que** la couche de réflexion (7) est disposée au moins partiellement dans un plan (18) parallèle et décalé par rapport au plan du cœur de guide d'onde (4) dans une direction s'éloignant du composant optoélectronique (6).

9. Circuit intégré photonique (1) selon l'une quelconque des revendications précédentes, **caractérisé en ce que** la structure émettrice (5) comprend une structure de réseau (24), et la structure émettrice (5) comprend en outre éventuellement une section évasée (21) du cœur de guide d'onde (3), où la largeur latérale (22) du cœur de guide d'onde (3) augmente dans la section évasée (21) dans la direction d'une extrémité (23) du cœur de guide d'onde (3).

10. Circuit intégré photonique (1) selon l'une quelconque des revendications précédentes, **caractérisé en ce que** la structure émettrice (5) comprend une section effilée du cœur de guide d'onde (3), où la largeur latérale (22) du cœur de guide d'onde (3) diminue dans la section effilée vers une extrémité (23) du cœur de guide d'onde (3).

11. Circuit intégré photonique (1) selon l'une quelconque des revendications précédentes, **caractérisé en ce que** la structure émettrice (5) comprend une structure de réseau avec une largeur latérale modulante et/ou une épaisseur modulante.

12. Circuit intégré photonique (1) selon l'une quelconque des revendications précédentes, **caractérisé en ce que** la structure émettrice (5) comprend une section en spirale vers l'intérieur du cœur de guide d'onde (3).

13. Circuit intégré photonique (1) selon l'une quelconque des revendications précédentes, **caractérisé en ce que** la structure émettrice (5) comprend une section du cœur de guide d'onde (3) avec une pluralité d'orifices dans le cœur de guide d'onde (3) et/ou avec une pluralité de segments disjoints du cœur de guide d'onde (3).

14. Procédé de fabrication d'un circuit intégré photonique (1) comprenant les étapes consistant à :
- prévoir un matériau de gaine (2) avec un cœur de guide d'onde (3) dans le matériau de gaine (2), le cœur de guide d'onde (3) s'étendant dans un plan de cœur de guide d'onde (4) et comprenant une structure émettrice (5) pour dévier et/ou diffuser et/ou coupler la lumière hors du cœur de guide d'onde (3) et émettre la lumière, et prévoir un composant optoélectronique (6) disposé à distance du plan du cœur de guide d'onde (4), où la structure émettrice (5) du cœur de guide d'onde (3) est caractérisée comme la section ou une fraction de la section du cœur de guide d'onde (3) qui est congruente avec le composant optoélectronique (6) lorsqu'elle est déplacée parallèlement perpendiculairement au plan du cœur de guide d'onde (4) ;
- prévoir une couche de réflexion (7) pour réfléchir la lumière émise par la structure émettrice (5) vers le composant optoélectronique (6), où au moins une partie de la couche de réflexion (7) est prévue dans un plan de réflexion (8, 9, 10, 11), lequel plan de réflexion (8, 9, 10, 11) intersecte le plan du cœur de guide d'onde (4), où le plan de réflexion (8, 9, 10, 11) est prévu sur un côté de la structure émettrice (5) par rapport à une direction de propagation (12) de la lumière dans le cœur de guide d'onde (3) dans la structure émettrice (5) de telle sorte que la lumière émise par la structure émettrice (5) dans une direction latérale puisse être réfléchie par la couche de réflexion (7).

15. Procédé selon la revendication 14, **caractérisé en ce que** le procédé comprend :
- la formation d'au moins une tranchée (19) dans le matériau de gaine (2) en éliminant sélectivement des parties du matériau de gaine (2), de préférence par gravure, de préférence au moins jusqu'au niveau du plan du cœur de guide d'onde (4), où la couche de réflexion (7) est au moins partiellement formée par une face latérale (20) de la tranchée (19).
